# EUROPEAN PATENT APPLICATION

(11) **EP 3 354 452 A1**
(43) Date of publication of application: **01.08.2018**
(21) Application number: 15906888.1
(22) Date of filing: 26.10.2015
(51) Int. Cl.: B32B 3/10, H05K 5/00

(54) **APPEARANCE STRUCTURAL MEMBER AND APPEARANCE STRUCTURAL MEMBER MANUFACTURING METHOD**

(71) Applicant: Huawei Technologies Co., Ltd., Longgang District Shenzhen, Guangdong 518129 (CN)
(72) Inventor: GU, Xugu, Shenzhen Guangdong 518129 (CN); WANG, Xiaofei, Shenzhen Guangdong 518129 (CN)
(74) Representative: Maiwald Patent- und Rechtsanwaltsgesellschaft mbH
(86) International application number: PCT/CN2015/092842
(87) International publication number: WO 2017/070822

(57) **Abstract**

This application provides an appearance mechanical part and a method for manufacturing an appearance mechanical part. The appearance mechanical part includes a substrate formed by jointing a metal component and an insulation component and an insulation appearance layer formed on a surface of the substrate and covering a jointed boundary line, where the jointed boundary line is a boundary line formed by the metal component and the insulation component on the surface of the substrate. The method includes: arranging a substrate, where the substrate is formed by jointing a metal component and an insulation component, and forming, on a surface of the substrate, an insulation appearance layer covering a jointed boundary line, where the jointed boundary line is a boundary line formed by the metal component and the insulation component on the surface of the substrate. According to the appearance mechanical part and the method for manufacturing an appearance mechanical part provided in embodiments of the present invention, the jointed boundary line is covered by using an insulation appearance layer, so that a color and gloss of a surface of the appearance mechanical part can be consistent, and structural strength of the appearance mechanical part can be increased.

## Description

### TECHNICAL FIELD

The present invention relates to the manufacturing field, and in particular, to an appearance mechanical part and a method for manufacturing an appearance mechanical part.

### BACKGROUND

Due to a unique color and texture and relatively high structural strength of a metal appearance mechanical part, more mobile terminal manufacturers are beginning to configure a metal appearance mechanical part on a mobile terminal. For example, more mobile phones use a metal mobile phone back cover or a metal mobile phone frame. However, because metal is generally an excellent conductor, when a metal appearance mechanical part has a relatively large surface area, the metal appearance mechanical part causes a relatively strong shielding effect on a radio signal, and affects antenna performance of a mobile terminal. For example, when an entire back cover of a mobile phone is made of metal, the back cover causes a shielding effect on an antenna signal of the mobile phone, and sending and receiving of radio signals by the mobile phone are affected.

To prevent an appearance structure from affecting antenna performance of a mobile terminal, a mobile terminal manufacturer usually uses an appearance mechanical part that is formed by jointing a metal part and an insulation part, so that the appearance mechanical part has relatively high structural strength without shielding a radio signal. A mobile phone back cover is used as an example. Generally, an existing metal mobile phone back cover is provided with an antenna breakpoint, and the antenna breakpoint is filled with an insulation material, so that the metal mobile phone back cover is changed from one relatively large metal sheet to a structure formed by jointing multiple relatively small metal sheets that are separated by an insulation material. In this way, a coverage area of a metal sheet is decreased, so that a shielding effect of the mobile phone back cover on a radio signal is reduced.

However, there exists a material difference between a metal material and an insulation material. When the metal material and the insulation material are jointed, a jointed boundary line is formed on a surface of the appearance mechanical part. In this case, the jointed boundary line results in difficulty of color and gloss consistency of the appearance mechanical part and the reduced structural strength of the appearance mechanical part.

### SUMMARY

Embodiments of the present invention provide an appearance mechanical part and a method for manufacturing an appearance mechanical part, to resolve problems of difficulty in color and gloss consistency of the appearance mechanical part and reduced structural strength of the appearance mechanical part due to a jointed boundary line.

According to a first aspect, an embodiment of the present invention provides an appearance mechanical part, including a substrate formed by jointing a metal component and an insulation component and an insulation appearance layer formed on a surface of the substrate and covering a jointed boundary line, where the jointed boundary line is a boundary line formed by the metal component and the insulation component on the surface of the substrate.

With reference to the first aspect, in a first possible implementation of the first aspect, the substrate is formed by jointing at least one metal component and at least one insulation component.

With reference to the first aspect, in a second possible implementation of the first aspect, the substrate is formed by jointing at least two metal components and at least one insulation component successively, and the metal components are electrically insulated.

With reference to any one of the first aspect or the first or the second possible implementation of the first aspect, in a third possible implementation of the first aspect, the surface of the substrate has multiple side faces; and the insulation appearance layer is formed on at least one side face, and there is a jointed boundary line on the at least one side face.

With reference to any one of the first aspect or the first to the third possible implementations of the first aspect, in a fourth possible implementation of the first aspect, the surface of the substrate has multiple side faces; and the insulation appearance layer is formed on at least two side faces of the surface of the substrate, and there is a jointed boundary line on at least one of the at least two side faces.

With reference to any one of the first aspect or the first to the third possible implementations of the first aspect, in a fifth possible implementation of the first aspect, the insulation appearance layer completely covers the surface of the substrate.

With reference to any one of the first aspect or the first to the fifth possible implementations of the first aspect, in a sixth possible implementation of the first aspect, the insulation appearance layer is made of metal oxide.

With reference to the sixth possible implementation of the first aspect, in a seventh possible implementation of the first aspect, the metal component is made of aluminum or aluminum alloy, and the insulation appearance layer is made of aluminum oxide.

With reference to any one of the first aspect or the first to the seventh possible implementations of the first aspect, in an eighth possible implementation of the first aspect, the insulation component is made of a plastic material used for a nano molding technology.

According to a second aspect, an embodiment of the present invention further provides a method for manufacturing an appearance mechanical part, including: arranging a substrate, where the substrate is formed by jointing a metal component and an insulation component, and forming, on a surface of the substrate, an insulation appearance layer covering a jointed boundary line, where the jointed boundary line is a boundary line formed by the metal component and the insulation component on the surface of the substrate.

With reference to the second aspect, in a first possible implementation of the second aspect, the arranging a substrate includes: arranging two metal components separated from each other; and injecting, between the two metal components by using a nano molding technology, a plastic material for connecting the two metal components, to form the substrate.

With reference to the second aspect or the first possible implementation of the second aspect, in a second possible implementation of the second aspect, the forming, on a surface of the substrate, an insulation appearance layer covering a jointed boundary line includes: depositing a to-be-oxidized metal layer on the surface of the substrate, where the to-be-oxidized metal layer covers the jointed boundary line; and completely oxidizing the to-be-oxidized metal layer, to form the insulation appearance layer.

With reference to any one of the second aspect or the first or the second possible implementation of the second aspect, in a third possible implementation of the second aspect, the to-be-oxidized metal layer and the metal component are made of a same material.

With reference to the third possible implementation of the second aspect, in a fourth possible implementation of the second aspect, when the to-be-oxidized metal layer is made of aluminum or aluminum alloy, the to-be-oxidized metal layer is completely oxidized by means of anodic oxidation to form an aluminum oxide membrane, to obtain the insulation appearance layer.

In the embodiments of the present invention, the appearance mechanical part includes a substrate formed by jointing a metal component and an insulation component and an insulation appearance layer formed on a surface of the substrate and covering a jointed boundary line, where the jointed boundary line is a boundary line formed by the metal component and the insulation component on the surface of the substrate, and the surface is a surface of which at least one of side faces of the substrate has the jointed boundary line. According to the embodiments of the present invention, the jointed boundary line is covered by using the insulation appearance layer, so that a color and gloss of a surface of the appearance mechanical part can be consistent, and structural strength of the appearance mechanical part can be increased.

### BRIEF DESCRIPTION OF DRAWINGS

To describe the technical solutions in the embodiments of the present invention or in the prior art more clearly, the following briefly describes the accompanying drawings required for describing the embodiments or the prior art. Apparently, a person of ordinary skill in the art may still derive other drawings from these accompanying drawings without creative efforts.
FIG. 1 is a schematic structural diagram of an embodiment of an appearance mechanical part according to the present invention;
FIG. 2 is a schematic structural diagram of another embodiment of an appearance mechanical part according to the present invention;
FIG. 3 is a schematic structural diagram of another embodiment of an appearance mechanical part according to the present invention;
FIG. 4 is a schematic structural diagram of another embodiment of an appearance mechanical part according to the present invention;
FIG. 5 is a schematic flowchart of an embodiment of a method for manufacturing an appearance mechanical part according to the present invention;
FIG. 6 is a schematic diagram of a process of manufacturing an appearance mechanical part according to the present invention;
FIG. 7 is a schematic diagram of a process of manufacturing an appearance mechanical part according to the present invention;
FIG. 8 is a schematic diagram of a process of manufacturing an appearance mechanical part according to the present invention;
FIG. 9 is a schematic diagram of a process of manufacturing an appearance mechanical part according to the present invention; and
FIG. 10 is a schematic diagram of a process of manufacturing an appearance mechanical part according to the present invention.

### DESCRIPTION OF EMBODIMENTS

To make a person skilled in the art understand the technical solutions in the present invention better, the following clearly and completely describes the technical solutions in the embodiments of the present invention with reference to the accompanying drawings in the embodiments of the present invention. Apparently, the described embodiments are merely a part rather than all of the embodiments of the present invention. All other embodiments obtained by a person of ordinary skill in the art based on the embodiments of the present invention without creative efforts shall fall within the protection scope of the present invention.

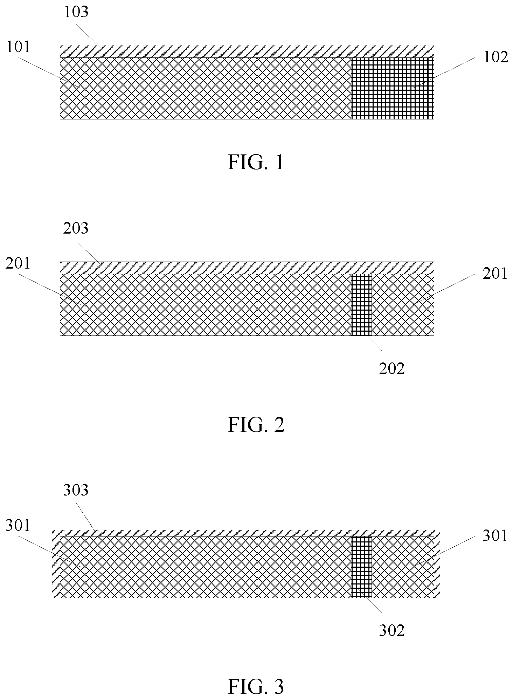

Referring to FIG. 1, FIG. 1 is a schematic diagram of an embodiment of an appearance mechanical part according to the present invention. The appearance mechanical part may be a mobile phone back cover, a mobile phone frame, or the like.

As shown in FIG. 1, the appearance mechanical part includes at least a substrate 10 formed by jointing a metal component 101 and an insulation component 102 and an insulation appearance layer 103 formed on a surface of the substrate 10.

The substrate 10 is formed by jointing the metal component 101 and the insulation component 102, but the metal component 101 and the insulation component 102 are made of different materials. Therefore, a jointed boundary interface is necessarily formed between the metal component 101 and the insulation component 102, and the jointed boundary interface forms at least one jointed boundary line on the surface of the substrate 10.

When the entire surface of the substrate 10 includes multiple side faces, the jointed boundary line may be distributed on the multiple side faces. A distribution status of the jointed boundary line on the side faces varies with a different manner of jointing the metal component 101 and the insulation component 102. When a spliced structure between the metal component 101 and the insulation component 102 is relatively complex or the metal component 101 and the insulation component 102 are of an irregular shape, some side faces of the substrate 10 may be distributed with only one jointed boundary line, while other side faces of the substrate 10 may be distributed with more than one jointed boundary line or may be not distributed with any jointed boundary line.

The metal component 101 may be made of metal or alloy having high strength and corrosion resistance, for example, aluminum, aluminum alloy, stainless steel, and titanium alloy. The insulation component 102 may be made of an insulation material having a specific structural strength. For ease of processing, generally, the insulation material may be a plastic material that may be used for a nano molding technology (Nano Molding Technology, NMT for short). A material of the insulation appearance layer may be selected by technical personnel according to a requirement. Generally, an insulation material having stable chemical properties, for example, ceramic and metal oxide, may be selected. To make the appearance mechanical part present metallic luster and have a metallic texture, the insulation appearance layer may be made of metal oxide having a similar texture to that of a material of the metal component 101. For example, when the metal component 101 is made of aluminum or aluminum alloy, the insulation appearance layer may be made of aluminum oxide. Herein, it should be noted that when the substrate includes multiple metal components 101, materials of the multiple metal components 101 may be the same or may be different. Similarly, when the substrate includes multiple insulation components 102, materials of the multiple insulation components 102 may be the same or may be different.

The substrate 10 needs to include at least one metal component and at least one insulation component. In actual use, a quantity of the metal components and a quantity of the insulation components may be set according to a requirement. When there are two or more metal components, the metal components need to be isolated by using an insulation component to implement electrical insulation. Generally, as shown in FIG. 2, the substrate may include at least two metal components 201 and at least one insulation component 202, or may include at least two insulation components and at least one metal component. According to a different application scenario of the appearance mechanical part, when the substrate includes multiple metal components and insulation components, a spacing between the metal components may be set according to a requirement. Generally, the spacing that may cause no shielding on a radio signal is a lower limit of the spacing between the metal components. A shape of the insulation component may vary with different shapes, spacings, and position relationships of the metal components.

A manner of jointing the metal component and the insulation component can be determined according to materials and quantities of the metal components and the insulation components, and generally, bonding, clamping, an NMT, and the like may be used. The manner of jointing the metal component and the insulation component may vary with different materials of the metal component and the insulation component. For example, when the substrate is formed by jointing one metal component and one insulation component, an embedded manner may be used to joint the metal component and the insulation component. When the substrate is formed by jointing two metal components and one insulation component, and the insulation component is made of a plastic material to which an NMT may be applied, the plastic material may be injected, by using the NMT technology, between the two metal components separated from each other, so that the plastic material injected between the two metal components forms the insulation component, so as to form the substrate. The plastic material to which the NMT may be applied may include phenylenesulfide (phenylenesulfide, PPS for short), polybutylene terephthalate (polybutylene terephthalate, PBT for short), polyethylene terephthalate (polyethylene terephthalate, PTT for short), polyamide (polyamide, PA for short), polyetheretherketone (polyetheretherketone, PEEK for short), and the like.

The surface of the substrate may include multiple side faces. The side face may be a plane, may be a curved surface such as a spherical surface or a saddle surface, or may be an irregular surface formed by splicing multiple planes or curved surfaces. For example, when the substrate is a cuboid formed by jointing two cuboid-shaped metal components and one cuboid-shaped insulation component, the surface of the substrate includes six side faces, and there is a jointed boundary line on four of the side faces. When the substrate is formed by jointing more metal components and insulation components, or when the metal component and the insulation component are of irregular shapes, the surface of the substrate may include more side faces, and there is a jointed boundary line on more side faces.

That the insulation appearance layer 103 is formed on the surface of the substrate 10 and covers at least the jointed boundary line means that the insulation appearance layer 103 covers at least a portion of a jointed boundary line on one of the side faces. That is, when there is one jointed boundary line on a side face, the insulation appearance layer may completely cover the jointed boundary line, or may cover only a portion of the jointed boundary line; and when there are two or more jointed boundary lines on a side face, the insulation appearance layer may cover all the jointed boundary lines, or may cover only one or some of the jointed boundary lines, or may cover only a portion of one or some of the jointed boundary lines.

Generally, when there is a jointed boundary line on a side face, to cover the jointed boundary line, the insulation appearance layer may cover only the side face having the jointed boundary line. As shown in FIG. 2, the insulation appearance layer 203 covers only one side face of the substrate.

According to a different actual requirement, the insulation appearance layer may alternatively cover all the side faces of the surface of the substrate completely or cover multiple side faces of the surface of the substrate. For example, as shown in FIG. 3, when the substrate is a cuboid formed by jointing two metal components 301 and one insulation component 302, there is a jointed boundary line on four side faces of the substrate, and there is no jointed boundary line on two side faces of the substrate. In this case, the insulation appearance layer 303 covers one side face having a jointed boundary line and the two side faces having no jointed boundary line.

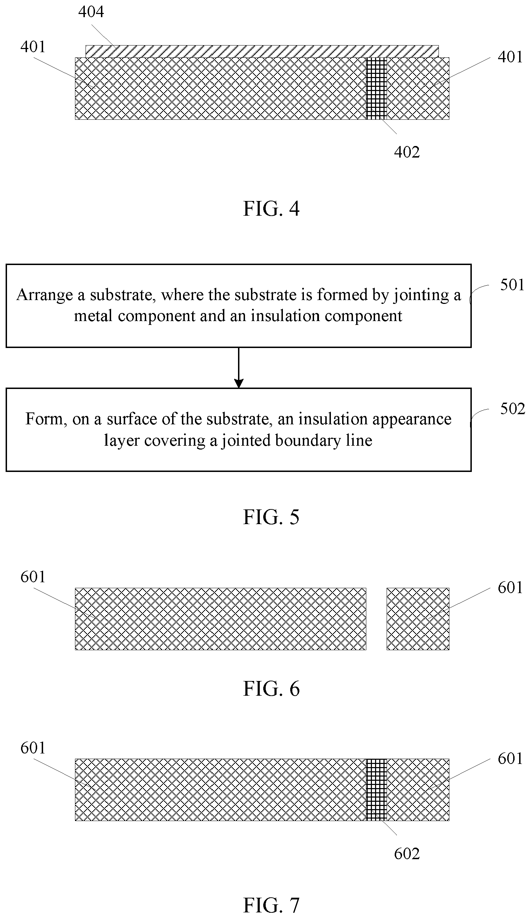

In actual use, for a purpose of saving materials or facilitating further processing, when the insulation appearance layer covers a side face, the insulation appearance layer may cover only a partial area of the side face. As shown in FIG. 4, when the substrate is a cuboid formed by jointing two metal components 401 and one insulation component 402, the insulation appearance layer 404 may cover only a partial area of a side face of the substrate. There is a jointed boundary line on the side face covered by the insulation appearance layer 404, and the insulation appearance layer 404 completely covers the jointed boundary line.

A manner of forming the insulation appearance layer on the substrate varies with a different material of the insulation appearance layer. Generally, the insulation appearance layer may be formed by depositing an insulation material. To make the insulation appearance layer have better physical stability and chemical stability, the insulation appearance layer may also be formed by first depositing metal or alloy on the insulation appearance layer and then completely oxidizing the deposited metal or alloy. A thickness of the insulation appearance layer may be set according to a requirement. For example, an insulation ceramic material may be deposited on the surface of the substrate directly, so that the insulation ceramic material is jointed with the substrate as a whole to form the insulation appearance layer. For another example, when the metal component is made of aluminum or aluminum alloy, a metal material that is the same as the material of the metal component may be deposited on the surface of the substrate, to form a to-be-oxidized metal layer; and then the to-be-oxidized metal layer is oxidized into metal oxide, so as to form the insulation appearance layer.

In this embodiment, the appearance mechanical part includes a substrate formed by jointing a metal component and an insulation component and an insulation appearance layer formed on a surface of the substrate and covering a jointed boundary line. The jointed boundary line of the appearance mechanical part can be covered by using the insulation appearance layer. In this way, color and gloss consistency of the appearance mechanical part due to the jointed boundary line can be avoided, and structural strength of the appearance mechanical part can be increased.

Corresponding to the appearance mechanical part provided in the present invention, the present invention further provides a method for manufacturing an appearance mechanical part.

Referring to FIG. 5, FIG. 5 is a schematic flowchart of an embodiment of a method for manufacturing an appearance mechanical part according to the present invention.

Step 501. Arrange a substrate, where the substrate is formed by jointing a metal component and an insulation component.

The substrate may be formed by compositing the metal component and the insulation component. For a specific material of the metal component and a specific material of the insulation component, refer to the foregoing embodiment. Details are not described herein again. For example, the substrate may be a mobile phone back cover, a mobile phone frame, or the like formed by compositing metal and plastic.

The metal component and the insulation component may be jointed by means of bonding, clamping, an NMT, and the like. A manner of jointing the metal component and the insulation component varies with different quantities and materials of metal components and insulation components. For a specific jointing manner, also refer to the foregoing embodiment. Details are not described herein again.

Optionally, during arrangement of the substrate, two metal components separated from each other may be first arranged, and then a plastic material for connecting the two metal components is injected between the two metal components by using a nano molding technology, to form the substrate.

An example in which the substrate includes two metal components and one insulation component is used. As shown in FIG. 6, two metal components 601 separated from each other may be first arranged. A spacing between the two metal components determines a thickness of an insulation component between the two metal components. After the metal components are arranged, as shown in FIG. 7, an insulation material is filled between the metal components to form an insulation layer 602 and implement jointing of the insulation component 602 and the metal components 601. When the insulation component is made of a plastic material, such as PPS, PBT, PCT, PTT, PA, and PEEK, to which an NMT may be applied, the plastic material may be injected, by using the NMT technology, between the two metal components separated from each other, so that the plastic material injected between the two metal components forms the insulation component that is jointed with the two metal components, so as to form the substrate.

Step 502. Form, on a surface of the substrate, an insulation appearance layer covering a jointed boundary line.

After the substrate is formed, one or more side faces of the surface of the substrate may be selected according to a requirement, and the insulation appearance layer is formed on the one or more side faces. The insulation appearance layer covers the jointed boundary interface. There is a jointed boundary line on at least one of the one or more selected side faces, and there is at least one jointed boundary line.

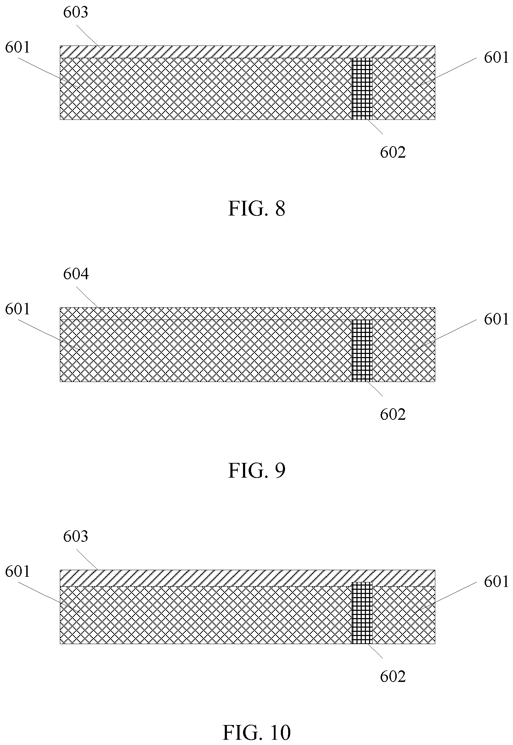

According to different materials of the metal component, the insulation component, and the insulation appearance layer, the insulation appearance layer may be formed in different manners. Generally, the insulation material may be directly deposited on the selected side face by means of deposition, such as physical vapor deposition (Physical Vapor Deposition, PVD for short) or chemical vapor deposition (Chemical Vapor Deposition, CVD for short). For example, the selected side face may be first sandblasted, and then as shown in FIG. 8, an insulation material is deposited on the surface by means of PVD, so as to form the insulation appearance layer 603.

When metal oxide is selected as a material of the insulation appearance layer, as shown in FIG. 9, a to-be-oxidized metal layer 604 may be deposited on the side face; and then, as shown in FIG. 10, the to-be-oxidized metal layer is completely oxidized to form the insulation appearance layer 603. The to-be-oxidized metal layer may be formed by means of PVD or CVD, and the insulation appearance layer may be formed by performing anodic oxidation on the to-be-oxidized metal layer. When the to-be-oxidized metal layer and the metal component are made of a same material. As shown in FIG. 10, to ensure that the to-be-oxidized metal layer is completely oxidized, the metal component may further be partially oxidized in addition to the to-be-oxidized metal layer.

For example, when the appearance mechanical part is a mobile phone back cover or a mobile phone frame, to ensure structural strength of the appearance mechanical part, the metal component of the appearance mechanical part is generally made of aluminum alloy, and the insulation component is generally made of engineering plastic. When the metal component is made of aluminum alloy and the insulation component is made of engineering plastic, the surface of the substrate may be first sandblasted. By means of sandblasting, impurities on the surface are removed, and the surface is roughened, so that the insulation appearance layer is bonded to the surface more closely. A shape of the substrate is a shape of the mobile phone back cover or the mobile phone frame of a mobile terminal. After sandblasting is performed, aluminum or aluminum alloy may be deposited on the surface to form the to-be-oxidized metal layer that is made of aluminum or aluminum alloy. After the to-be-oxidized metal layer is formed, the to-be-oxidized metal layer may be completely oxidized into aluminum oxide by means of anodic oxidation, so as to form the insulation appearance layer. A thickness of the to-be-oxidized metal layer may be set according to a requirement, but is required to be less than a maximum thickness of the to-be-oxidized metal layer that may be oxidized by means of anodic oxidation.

By using the appearance mechanical part manufactured according to this embodiment of the present invention, not only color and gloss inconsistency of the appearance mechanical part due to a jointed boundary line can be avoided, but also structure strength of the appearance mechanical part can be increased.

The embodiments in this specification are all described in a progressive manner, for same or similar parts in the embodiments, reference may be made to these embodiments, and each embodiment focuses on a difference from other embodiments. Especially, apparatus, server, and system embodiments are basically similar to a method embodiment, and therefore are described briefly; for related parts, reference may be made to partial descriptions in the method embodiment.

The foregoing descriptions are implementations of the present invention, but are not intended to limit the protection scope of the present invention. Any modification, equivalent replacement, and improvement made without departing from the spirit and principle of the present invention shall fall within the protection scope of the present invention.

## Claims

1. An appearance mechanical part, comprising:
a substrate formed by jointing a metal component and an insulation component; and
an insulation appearance layer formed on a surface of the substrate and covering a jointed boundary line, wherein
the jointed boundary line is a boundary line formed by the metal component and the insulation component on the surface of the substrate.

2. The appearance mechanical part according to claim 1, wherein
the substrate is formed by jointing at least one metal component and at least one insulation component.

3. The appearance mechanical part according to claim 1, wherein
the substrate is formed by jointing at least two metal components and at least one insulation component successively, and the metal components are electrically insulated.

4. The appearance mechanical part according to any one of claims 1 to 3, wherein
the surface of the substrate has multiple side faces; and
the insulation appearance layer is formed on at least one side face, and there is a jointed boundary line on the at least one side face.

5. The appearance mechanical part according to any one of claims 1 to 3, wherein
the surface of the substrate has multiple side faces; and
the insulation appearance layer is formed on at least two side faces of the surface of the substrate, and there is a jointed boundary line on at least one of the at least two side faces.

6. The appearance mechanical part according to any one of claims 1 to 3, wherein
the insulation appearance layer completely covers the surface of the substrate.

7. The appearance mechanical part according to any one of claims 1 to 6, wherein
the insulation appearance layer is made of metal oxide.

8. The appearance mechanical part according to claim 7, wherein
the metal component is made of aluminum or aluminum alloy, and the insulation appearance layer is made of aluminum oxide.

9. The appearance mechanical part according to any one of claims 1 to 8, wherein
the insulation component is made of a plastic material used for a nano molding technology.

10. A method for manufacturing an appearance mechanical part, comprising:
arranging a substrate, wherein the substrate is formed by jointing a metal component and an insulation component; and
forming, on a surface of the substrate, an insulation appearance layer covering a jointed boundary line; wherein
the jointed boundary line is a boundary line formed by the metal component and the insulation component on the surface of the substrate.

11. The method according to claim 10, wherein the arranging a substrate comprises:
arranging two metal components separated from each other; and
injecting, between the two metal components by using a nano molding technology, a plastic material for connecting the two metal components, to form the substrate.

12. The method according to claim 10 or 11, wherein the forming, on a surface of the substrate, an insulation appearance layer covering a jointed boundary line comprises:
depositing a to-be-oxidized metal layer on the surface of the substrate, wherein the to-be-oxidized metal layer covers the jointed boundary line; and
completely oxidizing the to-be-oxidized metal layer, to form the insulation appearance layer.

13. The method according to any one of claim 12, wherein the to-be-oxidized metal layer and the metal component are made of a same material.

14. The method according to claim 13, wherein the completely oxidizing the to-be-oxidized metal layer, to form the insulation appearance layer comprises:
when the to-be-oxidized metal layer is made of aluminum or aluminum alloy, completely oxidizing the to-be-oxidized metal layer by means of anodic oxidation to form an aluminum oxide membrane, to obtain the insulation appearance layer.
